# EUROPEAN PATENT APPLICATION

(11) **EP 2 066 166 A1**
(43) Date of publication of application: **03.06.2009**
(21) Application number: 07122030.5
(22) Date of filing: 30.11.2007
(51) Int. Cl.: H05K 13/08, H05K 13/04

(54) **Method for temperature compensation in a positioning system**

(71) Applicant: Mydata Automation AB, 168 66 Bromma (SE)
(72) Inventor: Axelsson, Robert, SE-125 74, Älvsjö (SE); Betzén, Olle, SE-177 42, Järfälla (SE); Ferm, Bobbi, SE-192 66, Sollentuna (SE); Österlund, Peter, SE-128 66, Sköndal (SE)
(74) Representative: Skagersten, Thomas

(57) **Abstract**

A positioning system and a method of compensating for thermal expansion variations in a positioning system, as well as a component mounting machine, a jet dispensing machine, and a dispensing machine, including such a positioning system. The positioning system includes an elongated beam (104) extending along an axis (x), where the shape of the beam (104) is subject to variations due to thermal expansion during operation of the positioning system. The system comprises a positioning unit (106) movably suspended on the beam (104), at least one motor for providing movement of the positioning unit (106) along the axis (x), and at least one work head (112) mounted to or integrated with the positioning unit (106). A shape permanent, elongated reference element (110) is provided, which has a longitudinal extension along the axis (x), substantially in parallel to the beam (104). A reference distance is measured between the positioning unit (106) and the reference element (110) at a plurality of locations along the axis (x). The measured reference distances are used during positioning of the positioning unit (106) for compensating for thermal expansion.

## Description

### Technical field of the invention

The present invention generally relates to the field of circuit board manufacturing. More specifically, the present invention relates to a positioning system and a method of compensating for thermal expansion variations in such a positioning system, the positioning system including an elongated beam extending along an axis, a positioning unit movably suspended on the beam, at least one motor for providing movement of the positioning unit along the axis, and at least one work head mounted to or integrated with the positioning unit.

### Technical background

Generally, within the field of manufacture and assembly of circuit boards, electronic components are mounted at a specific position on a substrate, such as a printed circuit board (PCB), by a pick-and-place or component mounting machine. The electronic components are picked from component feeder magazines and positioned on the substrate, for mechanical and/or electrical connection to the substrate, by a work head, often referred to as a pick-up head or component mounting head.

Prior to placing components on a substrate, the substrate has typically been provided with a viscous medium in the form of solder paste or glue at accurately determined locations on the substrate at which the component is to be placed and attached to the substrate. The application of the viscous medium is typically provided through screen printing, dispensing or jetting. Such dispensing or jetting is typically provided through a work head, also referred to as a dispensing or jetting head.

Servo controlled linear motions of the work head may be provided in the x and y directions, or along the x- and x-axes, i.e. in the general, horizontal plane of the circuit board, and in the Z direction, or along the Z-axis, i.e. vertically and generally perpendicular to the plane of the circuit board. For a work head used for jetting, there may be no need for providing motion of the work head in the Z direction, which however is vital for a dispensing and a component mounting head.

The continued miniaturization of electronic circuits continuously increases the demand for more accurate placement of components and viscous medium for attaching the components. In order to meet such demands and to also increase manufacturing speed, more powerful linear motors may be provided and preferably arranged closer to the work head to reduce or eliminate influence of motion transmission. However, a drawback of providing more powerful linear motors closer to the work head, is that excess heat is generated closer to the actual positioning location. This may result in thermal expansions of parts of the positioning system, which will have a detrimental impact on positioning placement accuracy.

### Summary of the invention

An object of the present invention is to provide an improved method of compensating for thermal expansions in a positioning system.

This and other objects are achieved according to the present invention by providing a positioning system, a method, a component mounting machine, a jetting machine and a dispensing machine having the features defined in the independent claims. Preferred embodiments are defined in the dependent claims.

According to a first aspect of the invention, there is provided a method of compensating for thermal expansion variations in a positioning system. The positioning system includes an elongated first beam extending along a first axis, the shape of said first beam being subject to variations due to thermal expansion during operation of said system, a positioning unit movably suspended on said first beam, at least one motor for providing movement of the positioning unit along said first axis, and at least one work head mounted to or integrated with said positioning unit. The method comprises the steps of providing a shape permanent, elongated reference element, said reference element having a longitudinal extension along said first axis, substantially in parallel to the first beam, measuring a reference distance between the positioning unit and the reference element at a plurality of locations along said first axis, and using said measured reference distances during positioning of said positioning unit for compensating for said thermal expansion.

According to a second aspect of the invention, there is provided a positioning system for positioning a work head. The positioning system , comprises an elongated first beam extending along a first axis, the shape of said first beam being subject to variations due to thermal expansion during operation of said system, a shape permanent, elongated reference element, said reference element having a longitudinal extension along said first axis, substantially in parallel to the first beam, and a positioning unit movably suspended on said first beam. The positioning unit comprising at least one motor for providing movement of the positioning unit along said first axis, at least one work head mounted to or integrated with said positioning unit, and a sensor for measuring a distance between the positioning unit and the reference element at a plurality of locations along said first axis.

According to a third aspect of the invention, there is provided a component mounting machine arranged for mounting electronic components onto substrates. The component mounting machine comprises a positioning system as mentioned in the preceding paragraph.

According to a fourth aspect of the invention, there is provided a jetting machine for jet dispensing of viscous medium onto substrates. The jetting device comprises a positioning system as mentioned in the preceding paragraph.

According to a fifth aspect of the present invention, there is provided a dispensing machine for dispensing of viscous medium onto substrates. The dispensing machine comprises a positioning system as mentioned in the preceding paragraph.

Thus, the present invention is based on the insight of providing a shape permanent reference element having a longitudinal extension and position essentially corresponding to that of a longitudinal beam carrying the positioning unit, and monitoring the variations in the distances between the reference element and a measurement position of the positioning unit. Thereby, the shape of the beam onto which the positioning unit is suspended can be continuously estimated during operation of the positioning system, and any deviations in the shape of the beam as a result of thermal expansions, resulting in turn in a varying deviation between the actual and the nominal position of the positioning unit, may be calculated and compensated for.

It should be noted that the term "shape permanent" as used herein is intended to refer to an element that is not subjected to shape variations due to thermal expansion. In other words, the shape permanent reference element maintains its shape and is essentially unaffected by temperature variations within the physical environment or machine for which it is intended.

A significant advantage of such a solution is that only changes in the shape of the beam which are the result of thermal expansion of the beam per se is measured, and not of thermal expansions and shape variations of elements in the system other than the beam. In all positioning systems, a longitudinal beam supporting a positioning unit is more or less affected by thermal expansions and shape variations of various elements supporting the beam, elements supporting the detection devices, e.g. cameras, as well as elements holding the reference positions. In the positioning system and method of the present invention, the impact from such thermal expansions and shape variations on the measurements of the distance between the positioning unit and the reference element is reduced, and in some cases even eliminated.

Furthermore, the positioning and extension of the shape permanent reference element substantially in parallel along the longitudinal extension beam enables very quick and efficient measurements of reference distances. This is due to the fact that at whatever location the positioning unit is located, a portion of the reference element is always present at that location. Thus, reference measurements can always be performed, whether the positioning unit is standing still or moving, without requiring any additional and time-consuming movements of the positioning unit. For the same reason, continuous measurements and adaptation to thermally induced shape changes of the beam is made possible, reducing or eliminating the requirement for time-consuming recalibration during the working process.

Also, the possibility to perform reference measurements at any location along the extension of the beam provides the possibility of estimating the shape of the beam. Thereby, any warp or deviation of the straightness of the beam as a result of thermal expansion can be detected and measured, both before and during working operation of the positioning system. Consequently, the shape of the beam may be continuously or intermittently estimated and updated during working operation of the positioning system. As a result thereof, any angular offset of the positioning unit may be estimated, for any given location along the beam, resulting from changes in the straightness, or longitudinal curvature, of the beam for a given location where the positioning unit is, or may be, suspended. Thereby, the offset of a selected position of a work head carried by the positioning unit resulting from said angular deviation, i.e. variation in the shape of the beam, may be estimated and compensated for, resulting in an improved accuracy in the positioning of the work head. Again, this may be performed during working operation of the positioning system, which even further improves the accuracy and efficiency of the positioning system.

A further advantage of providing the elongated reference element along and essentially parallel to the extension of the beam, as well as the possibility to perform measurements during running operation of the positioning system, is that the measurements are performed where the positioning unit is located. In other words, when the positioning unit and corresponding work head operates at a specific portion of the beam, the heat is generated and absorbed by the beam at that very portion of the beam, and the measurements of beam shape variations are also performed at that very portion. Thus, more measurements are performed where the generation of heat is greater, and where the shape variations consequently are likely to be greater, thus providing more accurate measurements of the beam shape variations.

As envisaged by the person skilled in the art, even though the description refers to positioning systems within the field of manufacture and assembly of circuit boards, such as for component mounting, jetting and dispensing machines, the invention disclosed herein is essentially applicable to any positioning system requiring high accuracy and being subject to position variations due to thermal expansions of a beam supporting a positioning unit. Furthermore, where in the summary of the invention and the following description of preferred embodiments, reference is made to a component mounting machine and corresponding work head in the form of a component mounting head, or pick-up head, the component mounting machine may be substituted for a jet dispensing or conventional dispensing machine, and the corresponding work head for a jetting head or a dispensing head.

Moreover, the positioning of a work head in the x- and y-directions in relation to a substrate could for instance be provided by moving the work head along the x- and y-axes, or by moving the work head along the x-axis and the substrate along the y-axis. A positioning system where the relative movement between the substrate and the work head is provided by moving the work head in both the x- and the y-direction is often labelled a gantry system, while a system where the work head is moved along the x-axis and the substrate is moved along a perpendicular axis is labelled a split-axis system. It should be noted that the present invention is not limited to any particular positioning system. On the contrary, the present invention is applicable to positioning systems of any suitable type, including the gantry and split-axis type of positioning systems.

In embodiments of the invention, an initial calibration measurement of the beam shape in relation to the shape of the reference element may be performed, where the distances between the elongated reference element and the positioning unit at a plurality of locations along the axis of the beam is measured prior to regular or working operation of the positioning system. Thereby, an initial shape of the beam may be estimated on the basis of these measurements, and information of the initial shape may be stored for calculating calibrated positioning coordinates from nominal positioning coordinates. Thereafter, the measurements of distances and beam shape variations at locations along the beam may be related to the stored information of initial beam shape.

It should be noted that the term "shape of the beam" does generally not correspond to the absolute shape of the beam, but rather to the shape of the change of the beam in relation to the shape of the reference element from one point in time to another. In other words, the method according to the invention compensates for imperfections in the shape of the elongated reference element, and there is no need to provide a perfectly straight reference element, only a shape permanent one. Thus, where "shape of the beam" is referred to herein, it is the shape, or shape changes, in relation to the shape of the reference element that is intended.

During operation of the positioning system according to embodiments of the invention, a shape of the beam may be determined or estimated based on measured reference distances during working operation of the positioning system and said initial shape information. The determination may be performed essentially continuously during working operation, and the shape of the beam essentially continuously updated and stored as working shape information for the shape of the beam. The working shape information may be used during operation of the positioning system to compensate, at least in a direction essentially perpendicular to the extension of the beam, for changes between the working shape of the beam and the initial shape of the beam, and for determining an offset of the work head from a nominal coordinate system of the positioning system, such that actual positioning coordinates may accurately be determined.

The changes in shape of the beam results not only in an offset in the position of the positioning unit and the work head in a direction essentially perpendicular to the extension of the beam, but also in an angular offset of the positioning unit resulting from a warp or curvature change due to thermal expansion of the beam material. Depending on the design of the positioning unit, and the positional relationship between a camera, work head and nominal center of the positioning unit, an offset in the x- and/or y-direction may arise as a result from said angular offset or deviation of the positioning unit. Furthermore, said angular offset, similar to the offset perpendicular to the beam extension, varies along the extension of the beam. Thus, at one point along the beam, there may be a not insignificant angular offset of the positioning unit, while at another point, the beam shape is such that there is essentially no angular offset at all of the positioning unit.

According to embodiments of the invention, measurements of the distance variations may be conducted by performing a continuous or essentially continuous measurement sweep along the beam. Then, a large number of measurements are performed at a large number of locations along the beam in order to obtain updated and accurate information of the shape of the beam. Such a measurement sweep is preferably performed prior to operation of the positioning unit, for instance when obtaining the initial shape information as discussed above. However, a measurement sweep may also be performed at other times during operation of the system. For instance, a measurement sweep may be performed if the difference between two subsequent measurements performed at the same location exceeds a preset threshold value. If so, this provides an indication that the beam shape variation is of a significant magnitude or rate and that a full update of the beam shape would be desirable.

Furthermore, the positioning system can be arranged to perform a sweep measurement of the beam shape whenever there is a time gap during which the positioning unit is not required or intended for working operation. In other words, if a measurement sweep can be performed in idle time of the positioning system, the system may be instructed to do so. Also, if the positioning system has been idle for a time period exceeding a certain threshold, a measurement sweep may be performed when working operation of the positioning system is resumed.

According to embodiments of the invention, measurement of the distance between the positioning unit and the elongated reference element is performed continuously, periodically or at chosen points in time, during regular working operation of the positioning system. Thereby, there is no delay whatsoever in the operating process of the positioning system for performing said measurements. Furthermore, as indicated above, the measurements are performed where the shape changes are expected to be the greatest, i.e. at locations along the first beam where the positioning unit is performing the regular positioning work.

According to embodiments of the invention, distance variations are obtained for a measured portion of the beam, and the shape of the entire beam, or at least a greater portion thereof, is estimated on the basis of the measurement results of said measured portion. In some embodiments, this may be performed by dividing the beam, or axis thereof, into a number of segments and estimating an updated beam shape when a sufficient number of said segments, compared to a threshold value, have sufficiently recent measurement results. The check for sufficiently recent measurement results can be performed by calculating the average age of the measurement results within a segment, and compare the average age to a threshold value. If the average age falls below the threshold value, then the measurement results are considered to be sufficiently recent. Furthermore, for each segment, the segment is considered updated when a number of measurement results exceeding a set threshold value for the number of measurement results have been obtained, and where the age of all of said measurement results falls below a set threshold value for the age of the measurement results. In exemplary embodiments, the estimation is performed using spline approximation. However, as understood by the skilled person, other suitable types of approximation algorithms may be used for estimating the shape of the entire beam from measurement results for only a portion of the beam.

Furthermore, any periodic vibrations that the elongated reference element might be subjected to may preferably be filtered out. For this purpose, a filter reducing or eliminating vibration components from the sensor signal of the reference distance measurements is provided. Thereby, a sensor signal essentially free of vibration components is obtained, and may be used for the subsequent determinations, calculations and estimations of beam shape.

The reference element may be of any suitable shape permanent and elongated type. For instance, the reference element may be in the form of a ribbon, band, wire, belt, or rod. Furthermore, the material of the reference element may be of any suitable type, such as metals, metal alloys, plastics, plastic polymers, etc.

In embodiments of the invention, the elongated reference element is suitably attached to the beam at opposite ends thereof, or at least at opposite ends of the portion of the beam for which measurement of shape variations is to be performed. In other words, the elongated reference element may be attached to the beam and extend only along a portion of the beam, or along the entire length of the beam. In particular embodiments, the attachment points of the reference element to the beam correspond to the attachment points of the beam to the frame of the positioning system. Thereby, the reference element is attached to the beam at attachment points where, due to the attachment of the beam to the frame, the movement of these attachment points in relation to an object of interest, for example a substrate onto which components are to be placed with high accuracy, is reduced.

Moreover, in embodiments of the invention, the sensor is preferably a sensor arranged for contactless distance measurements, such as an optical sensor, an inductive sensor, a radar sensor, an ultrasonic sensor, a capacitive sensor, or a magnetic sensor.

In embodiments of the invention where the positioning system is of a gantry type, the positioning unit may comprise a second beam movably suspended on a first beam, where the movements of the second beam generates heat and results in a thermal expansion of the first beam resulting in turn in an offset in the positioning of the positioning unit, i.e. the second beam. The second beam may, in turn, be provided with a second elongated reference element and a second positioning unit with a second sensor for measuring beam shape variations of the second beam. Thereby, in these embodiments, the beam shape of the first beam, as well as the beam shape of the second beam, may be determined and/or estimated, such that beam shape variations of the first and the second beam resulting from thermal expansion of said beams can be determined and compensated for during positioning of a work head carried by the second positioning unit.

It should be noted that in embodiments of a positioning system of the gantry type utilizing a second beam suspended on a first beam, one of the beams and positioning units may be provided with other means for suspension and positioning than linear guides and linear motors. For instance, the second beam may be provided with linear guides and the positioning unit suspended thereon be moved through the use of liner motors, while the movements of the second beam in relation to the first beam may be provided through lead screws, e.g. ball screws, belt drives, rack and pinion drives, etc., which does not generate surplus thermal energy to such a large extent as linear motors. Then, the second beam may be subjected to shape variations due to thermal expansion, while the first beam remains essentially stable in shape. Alternatively, the reverse situation may apply.

Also, the positioning system of the gantry type may comprise a beam subjected to shape variations due to thermal expansion, on which the positioning unit is suspended, which beam in turn is movably suspended on a pair of essentially parallel beams. Then, the parallel beams may be formed such that they are subjected to shape variations due to thermal expansion, or formed in a manner that they are not subjected to thermally induced shape variations.

### Brief description of the drawings

Further details and aspects of the present invention will become apparent from the following detailed description with reference to the accompanying drawings, in which:
Fig. 1 is a schematic perspective view of a component mounting machine comprising a positioning system according to embodiments of the present invention,
Figs. 2 and 3 are schematic illustrations of positioning systems of the split-axis and gantry type, respectively,
Fig. 4 is a schematic illustration of a positioning system of the split-axis type according to embodiments of the present invention,
Fig. 5 is a schematic illustration of a first gantry type positioning system according to embodiments of the present invention,
Fig. 6 is a schematic illustration of a second gantry type positioning system according to embodiments of the present invention,
Fig. 7. is an enlarged schematic illustration of a positioning unit of the embodiment shown in Fig. 4 shown in two different angular orientations, and
Figs. 8 and 9 are diagram illustrations of shape variations due to thermal expansion in a beam in a positioning system.

### Detailed description of the drawings

The present invention will now be further described in connection with the accompanying drawings. It should be noted, that even though a positioning system in a component mounting machine will be described and illustrated, the present invention is also applicable to positioning systems in other applications. Such applications include, but is not limited to, jet dispensing and conventional dispensing machines. Thus, the machine referred to in the following could be a component mounting machine, a jetting machine, a conventional dispensing machine, a combination thereof, or another machine with high demands for accurate positioning.

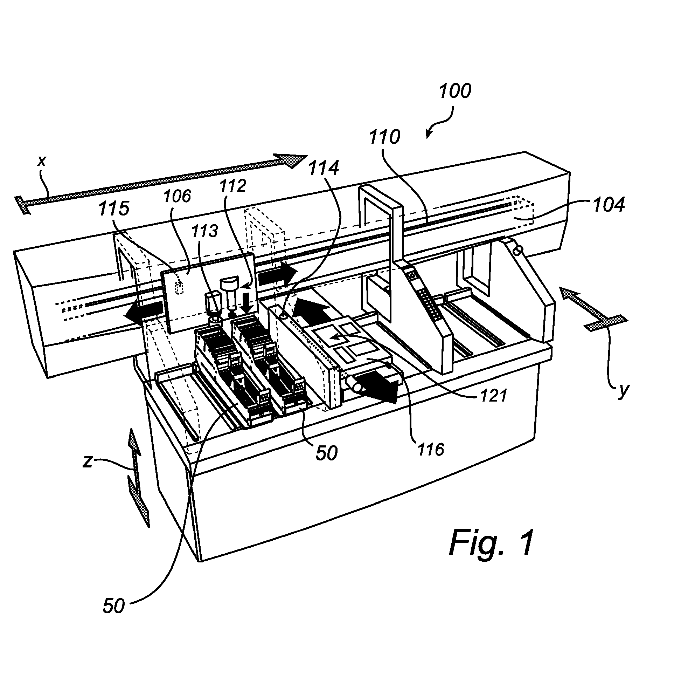

Figure 1 schematically shows a component mounting or pick and place machine 100 for mounting electronic components on printed circuit boards 121. The positioning system of the component mounting machine is of a split-axis type, in which the machine comprises a first axis, indicated by the arrow "x", along which a positioning unit 106 is moved, carrying a work or mounting head 112 and a sensing device 113, and a second axis, indicated by the arrow "y", along which a wagon 116 is moved, providing a working surface or working area, and carrying circuit boards 121 or other suitable substrates onto which components are to be placed. The x- and y-axes are essentially orthogonal. Thus, the machine 100 comprises a positioning system for positioning the work head 112 at a desired location in relation to the circuit boards 121.

Furthermore, the positioning system comprises linear motors (not shown) for movement of the positioning unit 106 and the wagon or board carrier 116. The machine 100 also comprises a control unit (not shown), e.g. a micro processor, for controlling the linear motors. The work head 112 is used for picking components from component feeder magazines 50 and placing them onto the circuit boards 121. The sensing device 113 is typically, as well as in the illustrated embodiments, in the form of a camera 113, which is connected to an image processing system, and used e.g. for calibrating the positioning system and verifying the position and orientation of the circuit boards.

A circuit board design determines the layout of the circuits on the circuit board 121, and the desired positions for different components. These positions are entered into the pick and place machine and converted into nominal or machine coordinates. Circuit boards 121, which have been printed according to the determined layout, and which are provided with solder paste, flux, or adhesive at the respective desired positions for the electronic components, are provided on the wagon 116. The control system of the machine controls the positioning system such that the work head 112 picks the correct type of component from a component supply or magazine 50 of component feeders, and positions the component at the desired location on the circuit board 121 according to the determined layout. The exact held position of the picked component when held by the mount head 112 is determined by a separate camera 114, and the machine compensates for any position or orientation offset when picking the component before placing the component on the board.

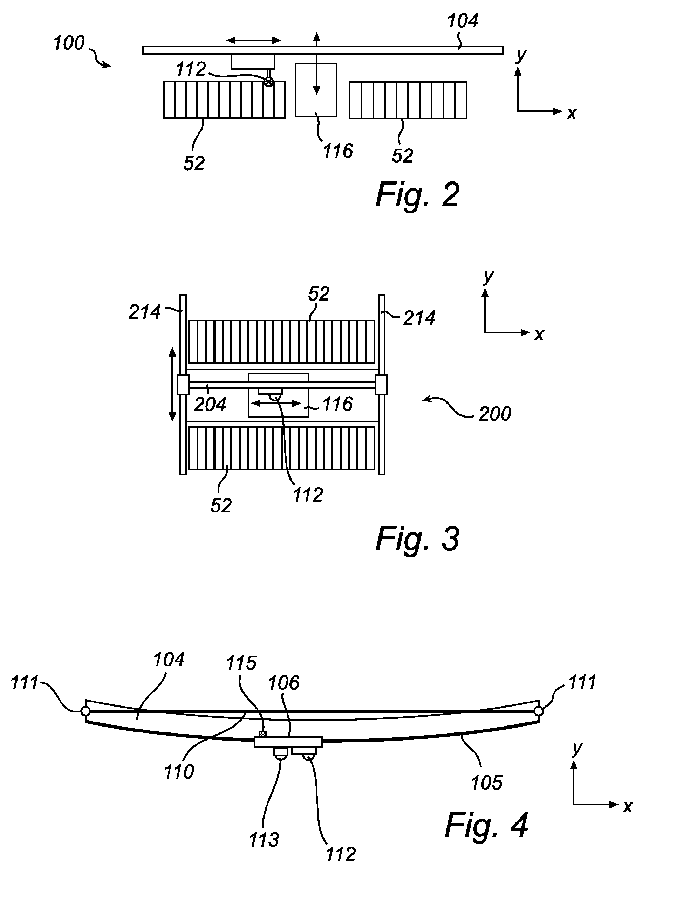

The positioning unit 106 is movably suspended with linear guides 105 (cf. Fig. 4) extending along an elongated beam 104. As mentioned above, linear motors (not shown) provides movement of the positioning unit and is provided in or on the positioning unit 106.

Turning to Figs. 2 and 3, there is schematically shown positioning systems of two alternative and conventional types to illustrate the difference thereof. Fig. 2 illustrates a split-axis machine 100, corresponding to the machine shown in Fig. 1. A work head 112 picks components from a component supply 52, preferably provided in magazines 50, and places the picked components on a circuit board carried by the wagon 116. The work head 112 is positioned along a first axis, x-axis, and the wagon 116 along a second axis, y-axis.

On the other hand, Fig. 3, illustrates a gantry machine 200, in which the wagon 116, and circuit boards carried by the wagon 116, is kept stationary, while the work head 112 places the components picked from a component supply 52. The work head is movable in a first direction (x) along a first beam 204. The beam 204 is, in turn, movable in a second direction (y) along second and third beams 214. In other words, the work head is positioned along both axes, while the substrate onto which components are to be placed remains stationary throughout the placement process.

Since movement of the positioning unit 106 is provided through one or more linear motors and the positioning unit 106 is suspended on linear guides along the elongated beam, a significant amount of heat is generated from movement of the positioning unit 106 during the pick and placement operation. The biggest temperature effect is caused by the large amount of heat generated by the linear motor(s) and by the linear guides 105 and absorbed by the beam 104. Firstly, the front side of the beam 104, i.e. the side facing the positioning unit 106, becomes warmer than the back side thereof. This results in a shape deformation of the beam 104 where the front side thereof expands more than the back side. Thereby, the beam 104 tends to bend towards the front of the machine towards the positioning unit 106 and work head 112, i.e. in the negative y direction. The exact deformation caused by the thermal expansion of the beam depends on where the heat is generated and absorbed by portions of the beam 104. For example, if the positioning unit 106 spends most if its time during the mounting process and movement of the positioning unit along the left portion of the beam 104, the deformation will be different than if the positioning unit 106 spends most of its time along the right portion of the beam 104.

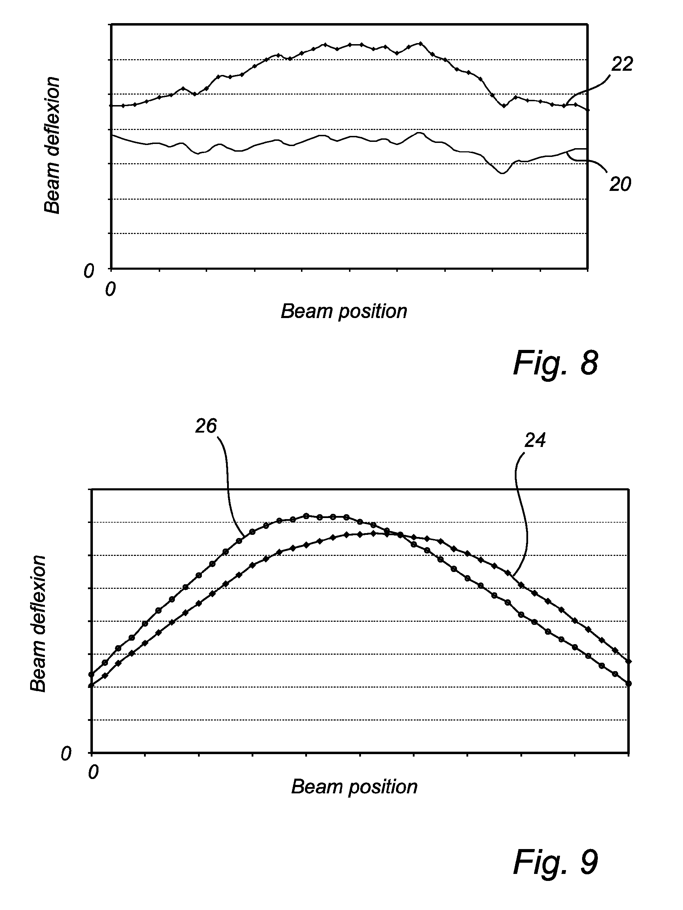

Turning briefly to Figs. 8 and 9, shape deformations of the beam 104 is illustrated in diagram form. In Fig. 8, graph 20 illustrates the initial shape of the beam as measured in relation to the reference element, and graph 22 illustrates the shape in relation to the reference element of the beam when en subjected to thermal expansion and resulting shape deformation.

In Fig. 9, the difference between the shape of a thermally deformed beam in relation to an initial shape is illustrated. Here, graph 24 represents the shape in relation to the reference element of a beam that has been subjected to symmetric heating, i.e. where the movements of the positioning unit has been symmetric along the extension of the beam. In contrast, graph 26 illustrates the shape in relation to the reference element of a beam that has been subjected to heat generating positioning unit movements with emphasis to the left portion of the beam. Here, it can clearly be seen that the deformation of the beam is dependent on the location of the heat generation. In other words, when the positioning unit operates more on one side of the beam, the beam deformation is larger on that side.

Turning now to Fig. 4 in conjunction with Fig. 1, a positioning system according to embodiments of the present invention will be further described. In order to determine the shape deformation of the beam 104 due to thermal expansion resulting from the heat generation during movement of the positioning unit 106, a steel wire, band, ribbon or belt 110 is provided along the extension of the beam 104. The steel band 110 is shape permanent through the temperature variations in the temperature range that the system is subjected to and is used as an elongated reference element 110 for measuring shape deformations of the beam. The steel band or reference element 110 is attached to the elongated beam 104 at two points, one to the left on the beam and one to the right on the beam, preferably at positions corresponding to where the beam 104 is attached to the frame of the machine 100. The reference element 110 is set up to have a high mechanical stress, which means that it will not bend or be otherwise deformed when the temperature changes. As realized by the skilled person, other types of elongated, shape permanent reference elements may also be contemplated for the method of the present invention, such as an elongated, slender rod. Also, other suitable materials are also contemplated for the shape permanent reference element, such as other metals or metal alloys, polymers, etc.

Furthermore, the positioning system comprises an inductive sensor 115 attached to the positioning unit. The sensor 115 measures the distance between the sensor 115 and the reference element 110 with very high accuracy, typically within 1 µm. Since the positioning unit 106, and hence the sensor 115, moves along the beam 104, the measurements of the sensor 115 may be used to estimate the shape of the beam 104. As understood by the skilled person, any other suitable type of non-contact measurement sensor may be used in the method of the present invention, such as optical sensors, e.g. laser sensors, capacitive sensors, radar sensors, ultrasonic sensors, and magnetic sensors.

Even though the shape permanent reference element or band 110 is not affected by the thermal variations of the positioning system, it does not have to be perfectly straight in order for the shape variations of the beam to be accurately monitored and measured. In order to compensate for any warpage or unevenness of the reference element 110, an initial reference shape calibration measurement is performed. Then, the distance between the reference element 110 and the sensor 115 is determined along the entire beam. Thereby, an initial shape of the beam is determined. Thereafter, any measurements of the distances between the sensor 115 and the reference element 110 are compared to the initial or reference shape in order to determine changes due to thermal expansions of the beam 104.

Then, the distance between the sensor 115 and reference element 110 is measured during operation of the positioning system, e.g. during normal pick and placement operations of the component mounting machine. Preferably, the distance measurements are periodically performed, independently of what the work head or positioning unit is doing. For instance, the sensor 115 may be polled every 1-50 ms, preferably every 5-10 ms. For every sensor reading, the current position along the x-axis and the current time are also recorded.

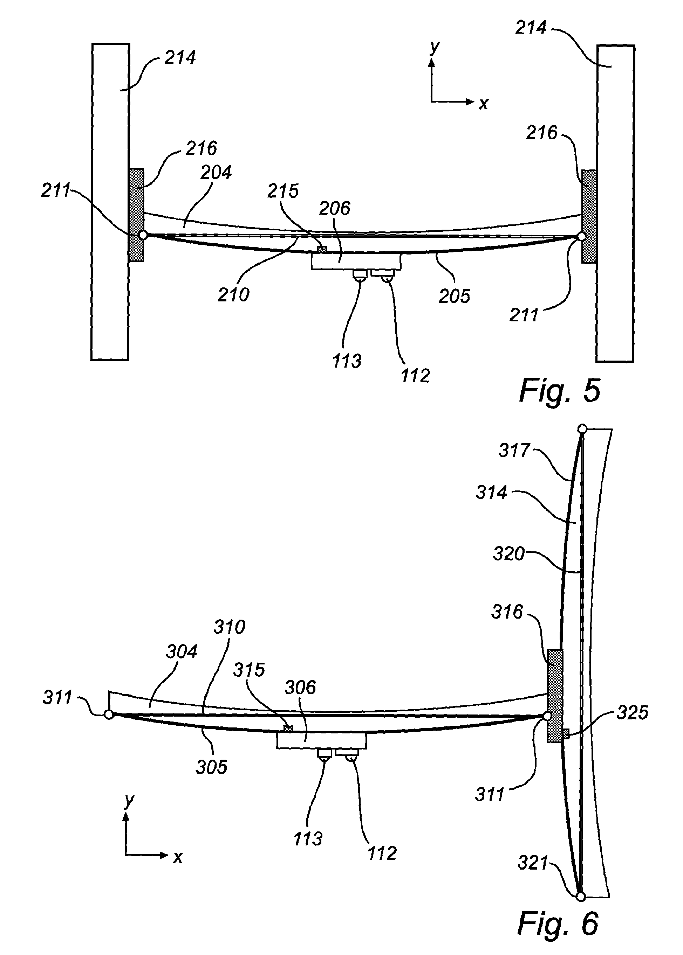

It should be noted that for purposes of illustration, the deformation of the beam 104 has been greatly exaggerated in Fig. 4, as well as in Figs. 5-7.

In Figs. 5 and 6, there are shown embodiments of positioning systems of the gantry type. With reference first to Fig. 5, a component mounting or pick and place machine 200 comprising an elongated beam 204 onto which a movable positioning unit 206 is suspended via linear guides 205. The positioning unit 206 carries a work head 112 and a camera 113, and comprises linear motors (not shown) for movement of the positioning unit 206 along the beam 204. An elongated reference element 210 extends along the extension of the beam 206, essentially in parallel thereto, and is attached at points 211 essentially corresponding to the attaching points of the beam. A sensor 215 for contactless measurements of the distance between the sensor 215 and the reference element 210 is also provided on the positioning unit. The functions of the elements of the embodiment shown in Fig. 5 correspond to the functions of the corresponding elements of the embodiment shown in Figs. 1 and 4.

The entire beam 204 is movably suspended at parallel elongated beams 214 extending essentially orthogonal to the extension of the beam 206. The parallel beams 214 do in this embodiment not comprise linear guides, but is provided with other suitable arrangements for suspension of the positioning units 216. Also, the positioning units 216 are not moved along the parallel beams 214 with the aid of linear motors, but other arrangements for providing movement are provided, e.g. lead screws, belt drives, rack and pinion drives, etc. Thereby, the positioning system is arranged to move the work head in both the x- and y-directions by moving the positioning unit 206 along the beam 204 in the x-direction, and by moving the entire beam 204 along the parallel beams 214 in the y-direction, the latter may be performed without excessive generation of heat resulting in the parallel beams 214 essentially maintaining their shape. Of course, embodiments where the parallel beams comprise linear guides and the positioning units comprise linear motors for providing movement of the beam are also conceivable for the present invention.

Turning to Fig. 6, there is shown another embodiment of a positioning system of the gantry type. As illustrated, the positioning system comprises a first beam 304 extending along the x-axis, the beam comprising linear guides 305 on which a first positioning unit 306 is suspended. An elongated reference element 310, a sensor 315, a work head 112 and a camera 113 are provided, in correspondence with the embodiment shown in Fig. 5. The elongated reference element 310 is attached, at least at one end thereof, to attachment points 311 on said first beam 304.

Furthermore, in the embodiment of Fig. 6, the first beam is movably suspended on a single second beam 314 through a second positioning unit 316 arranged with linear motors (not shown) for providing movement along the y-axis along linear guides 317 arranged on the second beam 314. Of course, the second positioning unit 316 and the first beam 314 can also be regarded as an aggregate positioning unit. The second positioning unit 316 comprises a sensor 325 for contactless measurement of the distance between the sensor, and thereby the positioning unit, and an elongated reference element 320 provided on the second beam 314. Thereby, beam shape variations of the second beam 314 due to thermal expansion of the beam may be measured during operation of the positioning system.

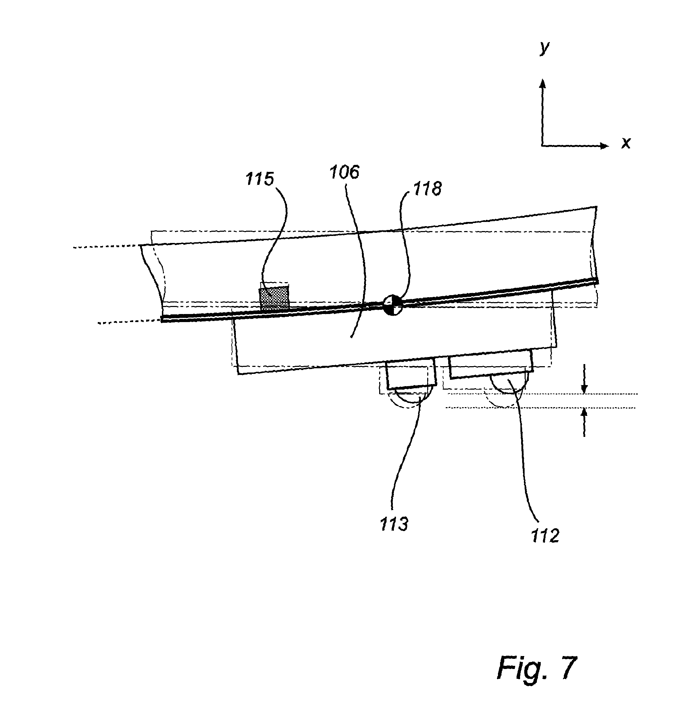

In Fig. 7, there is shown an enlarged portion of the positioning unit 106 of Fig. 4 at a position along the x-axis at one side of the beam where there is an angular offset, and a phantom view of the positioning unit at a position where there is no angular offset. In other words, the positioning unit is here shown at a location along the curvature of a beam that is bending due to thermal expansion, and, in phantom view, at a location which is essentially straight, i.e. essentially parallel to the elongated reference element which for illustrative purposes is not shown in Fig. 7. As can be clearly seen, the curvature of the beam at the shown position results in an angular offset in the orientation of the positioning unit in relation to the coordinate system of the machine. This, in turn, results in an offset to a varying extent in both the x-and y-directions between the nominal center 118 of the positioning unit and the work head 112 and/or camera 113, which generally have to be compensated for by the positioning system. In the presently illustrated embodiment, the work head 112 is located at a position which is somewhat closer to the indicated nominal center along the y-axis, but further from the nominal center along the x-axis. Thereby, an angular offset of the positioning unit results in an offset of the position of the work head 112, as indicated by lines and arrows in Fig. 7, and the camera 113 along the y-direction, which preferably is compensated for by the positioning system. In the x-direction, however, the offset is in the shown example significantly smaller, and may or may not be compensated for.

Thus, in operation, the distances between the sensor 115 and the reference element 110 is measured at a variety of locations along the extension of the beam 104, and the shape of the beam is estimated on the basis of the obtained measurement results. Thereby, the angular orientation or offset of the positioning unit 106 may be estimated for all positions along the beam 104, and the offset in the x- and y-directions may be calculated. In practice, there may be no need to calculate the angular deviation of the positioning unit at each location along the beam, but rather to calculate the offset in the y-, and possibly in the x-direction, of the work head 112 in relation to the camera 113 and possibly the sensor 115 directly from the estimated shape of the beam 104.

As readily understood, the positioning unit 316 on the second beam 314 in Fig. 6 is subjected to the same angular offset through thermal expansion of the second beam 314, resulting in a similar offset in the x- and y-directions of the first beam 304. However, due the elongated extension of the first beam 304 along the x-axis, the offset in the y-direction of positions along the first beam 304 becomes significant. Furthermore, the offset in the y-direction depends heavily on where along the first beam 304 the positioning unit 306 is located. Thus, the positioning system has to take into account the distance variations between the second beam 314 and the elongated reference element 320 resulting in an offset in the x-direction of the first beam 304 which varies along the position of the second beam, 314; the shape variations of the second beam 314 resulting primarily in an offset in the y-direction of the first beam 304 and the positioning unit 306 thereof; as well as the shape variations of the first beam 304 and the variations in distances between the first beam 304 and the reference element 310 thereof.

During operation of the positioning system according to all illustrated embodiments, the variations in the distances between the reference element and the positioning unit, and in turn the corresponding beam, and the shape of the corresponding beam is estimated and an offset in relation to the machine coordinate system is calculated, updated and stored. When positioning the work head for picking or placing a component, when used in a component mounting machine, the stored offset information is used such that the offset of the work head in relation to nominal machine coordinates is compensated for. Thereby, an accurate positioning of the work head is possible without time-consuming recalibration of the positioning system during operation of the system.

The beam shape may additionally be measured whenever desired by performing a measurement along essentially the entire beam, or at least at a selected portion of the beam where it is of interest to know the beam shape. Then, the measurements may be conducted by performing a continuous or close to continuous sweep along the axis of the beam. For instance, such a sweep may be performed as an initial calibration measurement before operation of the positioning system, at selected time intervals, when the time since the last spline approximation has reached a chosen threshold value, when the time since the last measurements for a portion of the beam has exceeded a threshold value, when the difference between two subsequent measurements for essentially the same location has exceeded a chosen threshold value, or when desired according to any other chosen suitable criteria. Furthermore, the positioning system may be programmed to perform a measurement sweep whenever the system is between regular positioning operation long enough for a measurement sweep to be conducted without delaying processing time, i.e. such that the measurement sweep is performed during idle time of the machine.

As understood by the skilled person, the sensor signal is subjected to suitable filtering for acquiring sufficiently accurate results. First, the reference or initial shape is subtracted. Since the position along the x-axis is recorded with each sensor reading, the reference shape correction may be easily obtained for that position and subtracted from the measured value. Secondly, the sensor reading may depend on the speed of the positioning unit. Since both the position along the x-axis and the current time is recorded with each sensor reading, and the position and time values are very accurate, the skilled person may readily compute the current speed of the positioning unit, compute a correction term and add it to the sensor signal. Thirdly, the reference element may vibrate with varying amplitude and frequency. One major source of vibrations source is the movement of the wagon 116 carrying the substrate, but other movements of the system may have a vibrating impact on the reference element 110. These vibrations may be filtered out using a suitable algorithm as readily envisaged by the skilled person.

After said filters have been applied to the sensor signal, a series of data points is acquired, where each data point comprises information of a time, a position along the x-axis, and a noise-free measurement value. The shape of the beam 104 will typically be a smooth function along the direction of the beam, i.e. in the x-direction, for any given point in time. However, the time dependence can be quite irregular, depending on how hard and at which portion of the beam the machine is working

The beam shape may be estimated by means of a spline approximation in the direction of the beam and a correction which is polynomial in said direction and piecewise linear in the time direction. The spline approximation is valid for all positions along the x-axis and one point in time. The spline may be computed whenever enough data is available to accurately compute it. There must be data for a large number of different positions along the x-axis and the data must be sufficiently recent. A number of different positions along the x-axis are required to make the spline well defined for all positions along the x-axis, and the "not too old" criteria ensures that the beam shape has not had time to change since the data point was measured.

An example showing details of a suitable spline approximation is as follows:
1. The x-axis is divided into a number of segments, where each segment is 10 cm long. The 25 most recent data points for each segment are stored.
2. If the average age of the measurement data for a segment is less than 15 s, the measurement data for that segment may be considered recent enough.
3. If more than 70% of the segments have measurement data that are considered recent enough, the spline approximation may be recomputed using all stored data for all segments.
4. Computing the spline approximation as a linear combination of B-spline basis functions using the method of least squares.

It may happen that a certain time exceeding a set threshold value has passed without there being enough data to recompute the spline approximation, for example if the machine is picking all components from the same side, if the machine is idle, or if the operator is adjusting pick positions. In such cases, the change of the beam shape between the last spline approximation and the current time is estimated with a simple parabolic function, which is assumed to be zero at the left and right end points of the x-axis. This is often sufficient for small corrections, and it has the advantage that there are only two unknown parameters, so the estimate can be computed even if data for only one position along the x-axis is available.

It should be noted that in the above described embodiments, the work of linear motors for moving positioning units is the source of heat generation that results in thermal expansion of the beam(s). However, the present invention is equally applicable in other embodiments where other heat sources provide thermal expansion of beams in positioning systems utilizing other positioning arrangements for movements of positioning units. Such other positioning arrangements includes, but are not limited to, lead screws, belt drives, rack and pinion drives, etc. Also, the invention is applicable to positioning systems where a beam is subjected shape variations resulting from heat generation from a positioning arrangement, such as motors, as well as from other heat sources.

Furthermore, even though the invention has been described above using exemplifying embodiments thereof, alterations, modifications and combinations thereof, as understood by those skilled in the art, may be made within the scope of the invention, which is defined by the accompanying claims.

## Claims

1. Method of compensating for thermal expansion variations in a positioning system, the positioning system including an elongated first beam extending along a first axis, the shape of said first beam being subject to variations due to thermal expansion during operation of said system, a positioning unit movably suspended on said first beam, at least one motor for providing movement of the positioning unit along said first axis, and at least one work head mounted to or integrated with said positioning unit, comprising the steps of:
providing a shape permanent, elongated reference element, said reference element having a longitudinal extension along said first axis, substantially in parallel to the first beam;
measuring a reference distance between the positioning unit and the reference element at a plurality of locations along said first axis; and
using said measured reference distances during positioning of said positioning unit for compensating for said thermal expansion.

2. The method as claimed in claim 1, comprising performing an initial calibration measurement of the positioning system, including the steps of:
measuring the initial distance, respectively, between the positioning unit and the reference element at a plurality of locations along said first axis prior to working operation of the positioning system;
determining an initial shape of said first beam in relation to said reference element on the basis of said measurement of initial distances; and
storing information of said initial shape as calibration information.

3. The method as claimed in claim 2, further comprising the steps of:
determining a working shape of the first beam on the basis of said measured reference distances and said calibration information; and
using said working shape information to compensate for changes between said working shape and said initial shape.

4. The method as claimed in claim 2 or 3, wherein said thermal expansion of said first beam results in an offset, in a direction essentially perpendicular to said first axis, of the points of suspension of the positioning unit to a varying extent at at least two positions along said first axis, comprising the step of
compensating, using said working shape information, the position of said positioning unit in a direction essentially perpendicular to said first axis.

5. The method as claimed in any one of claims 2-4, wherein said thermal expansion of said first beam results in a deviation of an angular orientation of said positioning unit, comprising the steps of:
determining said deviation of angular orientation for at least one location along said first axis using said working shape information; and
compensating the position of said positioning unit in a direction along said first axis, as well as in a direction essentially perpendicular to said first axis, on the basis of said determined deviation.

6. The method as claimed in claim 5, wherein said compensation of the position of the positioning unit as a result of said angular deviation is based on information related to the position of the positioning unit and nominal distances between the work head and a nominal center of the positioning unit.

7. The method as claimed in any one of the preceding claims, comprising the step of
measuring reference distances through an essentially continuous measurement sweep along said first axis.

8. The method as claimed in claim 7, wherein such a measurement sweep is performed during an initial calibration measurement of the positioning system.

9. The method as claimed in claim 7 or 8, wherein a measurement sweep is performed following a pre-programmed time period since a previous measurement sweep.

10. The method as claimed in any one of claims 7-9, wherein a measurement sweep is performed if one or more measurements of reference distances at one or more locations along said first axis indicates one or more distance changes exceeding one or more pre-programmed threshold values, said one or more distance changes preferably being changes since the preceding measurement sweep.

11. The method as claimed in any one of the preceding claims, comprising the step of
measuring reference distances during regular positioning and operation of the positioning unit and work head.

12. The method as claimed in claim 11, wherein said reference distances are continuously measured and the result of each measurement is stored.

13. The method as claimed in any one of the preceding claims, comprising the step of:
estimating the shape of the first beam on the basis of measured reference distances at locations along said first axis extending only along a portion of the first beam.

14. The method as claimed in claim 13, comprising the steps of:
dividing a portion of interest of said first axis into M number of segments,
storing the N most recent reference distance measurements for each segment,
determining and updating the shape of the first beam for each segment when, for a predetermined number of segments, a predetermined number of sufficiently recent reference distance measurements within each segment are stored, and
estimating the shape of the first beam, at least along said divided portion of interest of said first axis, on the basis of determined and updated shape of the first beam in one or more segments.

15. The method as claimed in any one of claims 13-14, wherein said step of estimating the shape of the first beam is performed using spline approximation.

16. The method as claimed in any one of the preceding claims, comprising the step of:
compensating for periodic vibrations of the reference element by applying a filter reducing or eliminating vibration components from the reference distance measurements.

17. The method as claimed in any one of the preceding claims,
wherein the reference element is selected from the group consisting of a wire, a band, a ribbon, a belt, and a rod.

18. The method as claimed in any one of the preceding claims,
wherein the reference element is attached to the first beam at opposite ends of said first beam along said first axis.

19. The method as claimed in claim 18, wherein the reference element is attached to the first beam at positions along said first axis where the first beam is in turn attached to the frame of said positioning system.

20. The method as claimed in any one of the preceding claims,
wherein said step of measuring said reference distances is performed through contactless measurement.

21. The method as claimed in claim 20, wherein said contactless measurement is performed using a sensor selected from the group of an optical sensor, an inductive sensor, a radar sensor, an ultrasonic sensor, a capacitive sensor, and a magnetic sensor.

22. The method as claimed in any one of the preceding claims,
wherein said positioning unit is a second beam movably suspended on said first beam, and having a further positioning unit movably mounted to said second beam, said further positioning unit carrying said work head.

23. The method as claimed in any one of claims 1-21, wherein said first beam is movably suspended on a second beam along a second axis essentially perpendicular to said first axis, such that the work head may be positioned along said first axis and along a second axis essentially perpendicular to said first axis.

24. The method as claimed in any one of claims 1-23, wherein the positioning system is a gantry system.

25. The method as claimed in any one of claims 1-21, wherein said first beam is rigidly mounted in the positioning system such that the work head is movable essentially along said first axis only, and wherein relative movement along a second axis, essentially perpendicular to said first axis, between the work head and a working surface or working area is achieved by movement of said working surface or working area along said second axis.

26. A positioning system for positioning a work head, comprising:
an elongated first beam extending along a first axis, the shape of said first beam being subject to variations due to thermal expansion during operation of said system,
a shape permanent, elongated reference element, said reference element having a longitudinal extension along said first axis, substantially in parallel to the first beam, and
a positioning unit movably suspended on said first beam, the positioning unit comprising at least one motor for providing movement of the positioning unit along said first axis, at least one work head mounted to or integrated with said positioning unit, and a sensor for measuring a distance between the positioning unit and the reference element at a plurality of locations along said first axis.

27. The system as claimed in claim 26, wherein the reference element is selected from the group consisting of a wire, a band, a ribbon, a belt, and a rod.

28. The system as claimed in claim 25 or 26, wherein the reference element is attached to the first beam at opposite ends of said first beam along said first axis.

29. The system as claimed in claim 27, wherein the reference element is attached to the first beam at positions along said first axis where the first beam is in turn attached to said positioning system.

30. The system as claimed in any one of claims 25-29, wherein said sensor is arranged for contactless measurements.

31. The system as claimed in any one of claims 25-30, wherein said sensor is selected from the group of an optical sensor, an inductive sensor, a radar sensor, an ultrasonic sensor, a capacitive sensor, and a magnetic sensor.

32. The system as claimed in any one of claims 25-31, wherein said positioning unit is a second beam movably suspended on said first beam, and having a further positioning unit movably mounted to said second beam, said further positioning unit carrying said work head.

33. The system as claimed in any one of claims 25-31 ,wherein said first beam is movably suspended on a second beam along a second axis essentially perpendicular to said first axis, such that the work head may be positioned along said first axis and along a second axis essentially perpendicular to said first axis.

34. The system as claimed in any one of claims 25-33, wherein the positioning system is a gantry system.

35. The system as claimed in any one of claims 25-31, wherein said first beam is rigidly mounted in the positioning system such that the work head is movable essentially along said first axis only, and wherein relative movement along a second axis, essentially perpendicular to said first axis, between the work head and a working surface or working area is achieved by movement of said working surface or working area along said second axis.

36. A component mounting machine arranged for mounting electronic components onto substrates, comprising a positioning system as claimed in any one of claims 25-35.

37. A jetting machine for jet dispensing of viscous medium onto substrates, comprising a positioning system as claimed in any one of claims 25-35.

38. A dispensing machine for dispensing of viscous medium onto substrates, comprising a positioning system as claimed in any one of claims 25-35.

## Amended claims

### Amended claims in accordance with Rule 137(2) EPC.

**1.** Method of compensating for thermal expansion variations in a positioning system, the positioning system including an elongated first beam extending along a first axis, the shape of said first beam being subject to variations due to thermal expansion during operation of said system, a positioning unit movably suspended on said first beam, at least one motor for providing movement of the positioning unit along said first axis, and at least one work head mounted to or integrated with said positioning unit, comprising the steps of:
providing a shape permanent, elongated reference element, said reference element having a longitudinal extension along said first axis, substantially in parallel to the first beam;
measuring a reference distance between the positioning unit and the reference element at a plurality of locations along said first axis; and
using said measured reference distances during positioning of said positioning unit for compensating for said thermal expansion.

**2.** The method as claimed in claim 1, comprising performing an initial calibration measurement of the positioning system, including the steps of:
measuring the initial distance, respectively, between the positioning unit and the reference element at a plurality of locations along said first axis prior to working operation of the positioning system;
determining an initial shape of said first beam in relation to said reference element on the basis of said measurement of initial distances; and
storing information of said initial shape as calibration information.

**3.** The method as claimed in claim 2, further comprising the steps of:
determining a working shape of the first beam on the basis of said measured reference distances and said calibration information; and
using said working shape information to compensate for changes between said working shape and said initial shape.

**4.** The method as claimed in claim 2 or 3, wherein said thermal expansion of said first beam results in an offset, in a direction essentially perpendicular to said first axis, of the points of suspension of the positioning unit to a varying extent at at least two positions along said first axis, comprising the step of
compensating, using said working shape information, the position of said positioning unit in a direction essentially perpendicular to said first axis.

**5.** The method as claimed in any one of claims 2-4, wherein said thermal expansion of said first beam results in a deviation of an angular orientation of said positioning unit, comprising the steps of:
determining said deviation of angular orientation for at least one location along said first axis using said working shape information; and
compensating the position of said positioning unit in a direction along said first axis, as well as in a direction essentially perpendicular to said first axis, on the basis of said determined deviation.

**6.** The method as claimed in claim 5, wherein said compensation of the position of the positioning unit as a result of said angular deviation is based on information related to the position of the positioning unit and nominal distances between the work head and a nominal center of the positioning unit.

**7.** The method as claimed in any one of the preceding claims, comprising the step of
measuring reference distances through an essentially continuous measurement sweep along said first axis.

**8.** The method as claimed in claim 7, wherein such a measurement sweep is performed during an initial calibration measurement of the positioning system.

**9.** The method as claimed in claim 7 or 8, wherein a measurement sweep is performed following a pre-programmed time period since a previous measurement sweep.

**10.** The method as claimed in any one of claims 7-9, wherein a measurement sweep is performed if one or more measurements of reference distances at one or more locations along said first axis indicates one or more distance changes exceeding one or more pre-programmed threshold values, said one or more distance changes preferably being changes since the preceding measurement sweep.

**11.** The method as claimed in any one of the preceding claims, comprising the step of
measuring reference distances during regular positioning and operation of the positioning unit and work head.

**12.** The method as claimed in claim 11, wherein said reference distances are continuously measured and the result of each measurement is stored.

**13.** The method as claimed in any one of the preceding claims, comprising the step of:
estimating the shape of the first beam on the basis of measured reference distances at locations along said first axis extending only along a portion of the first beam.

**14.** The method as claimed in claim 13, comprising the steps of:
dividing a portion of interest of said first axis into M number of segments,
storing the N most recent reference distance measurements for each segment,
determining and updating the shape of the first beam for each segment when, for a predetermined number of segments, a predetermined number of sufficiently recent reference distance measurements within each segment are stored, and
estimating the shape of the first beam, at least along said divided portion of interest of said first axis, on the basis of determined and updated shape of the first beam in one or more segments.

**15.** The method as claimed in any one of claims 13-14, wherein said step of estimating the shape of the first beam is performed using spline approximation.

**16.** The method as claimed in any one of the preceding claims, comprising the step of:
compensating for periodic vibrations of the reference element by applying a filter reducing or eliminating vibration components from the reference distance measurements.

**17.** The method as claimed in any one of the preceding claims,
wherein the reference element is selected from the group consisting of a wire, a band, a ribbon, a belt, and a rod.

**18.** The method as claimed in any one of the preceding claims,
wherein the reference element is attached to the first beam at opposite ends of said first beam along said first axis.

**19.** The method as claimed in claim 18, wherein the reference element is attached to the first beam at positions along said first axis where the first beam is in turn attached to the frame of said positioning system.

**20.** The method as claimed in any one of the preceding claims,
wherein said step of measuring said reference distances is performed through contactless measurement.

**21.** The method as claimed in claim 20, wherein said contactless measurement is performed using a sensor selected from the group of an optical sensor, an inductive sensor, a radar sensor, an ultrasonic sensor, a capacitive sensor, and a magnetic sensor.

**22.** The method as claimed in any one of the preceding claims,
wherein said positioning unit is a second beam movably suspended on said first beam, and having a further positioning unit movably mounted to said second beam, said further positioning unit carrying said work head.

**23.** The method as claimed in any one of claims 1-21, wherein said first beam is movably suspended on a second beam along a second axis essentially perpendicular to said first axis, such that the work head may be positioned along said first axis and along a second axis essentially perpendicular to said first axis.

**24.** The method as claimed in any one of claims 1-23, wherein the positioning system is a gantry system.

**25.** The method as claimed in any one of claims 1-21, wherein said first beam is rigidly mounted in the positioning system such that the work head is movable essentially along said first axis only, and wherein relative movement along a second axis, essentially perpendicular to said first axis, between the work head and a working surface or working area is achieved by movement of said working surface or working area along said second axis.

**26.** A positioning system for positioning a work head, comprising:
an elongated first beam (104, 204, 304) extending along a first axis, the shape of said first beam being subject to variations due to thermal expansion during operation of said system,
a shape permanent, elongated reference element (110, 210, 310), said reference element having a longitudinal extension along said first axis, substantially in parallel to the first beam, and
a positioning unit (106, 206, 306) movably suspended on said first beam, the positioning unit comprising at least one motor for providing movement of the positioning unit along said first axis, at least one work head (112) mounted to or integrated with said positioning unit, and a sensor (115, 215, 315) for measuring a distance between the positioning unit and the reference element at a plurality of locations along said first axis.

**27.** The system as claimed in claim 26, wherein the reference element is selected from the group consisting of a wire, a band, a ribbon, a belt, and a rod.

**28.** The system as claimed in claim 25 or 26, wherein the reference element is attached to the first beam at opposite ends of said first beam along said first axis.

**29.** The system as claimed in claim 27, wherein the reference element is attached to the first beam at positions along said first axis where the first beam is in turn attached to said positioning system.

**30.** The system as claimed in any one of claims 25-29, wherein said sensor is arranged for contactless measurements.

**31.** The system as claimed in any one of claims 25-30, wherein said sensor is selected from the group of an optical sensor, an inductive sensor, a radar sensor, an ultrasonic sensor, a capacitive sensor, and a magnetic sensor.

**32.** The system as claimed in any one of claims 25-31, wherein said positioning unit is a second beam movably suspended on said first beam, and having a further positioning unit movably mounted to said second beam, said further positioning unit carrying said work head.

**33.** The system as claimed in any one of claims 25-31, wherein said first beam is movably suspended on a second beam along a second axis essentially perpendicular to said first axis, such that the work head may be positioned along said first axis and along a second axis essentially perpendicular to said first axis.

**34.** The system as claimed in any one of claims 25-33, wherein the positioning system is a gantry system.

**35.** The system as claimed in any one of claims 25-31, wherein said first beam is rigidly mounted in the positioning system such that the work head is movable essentially along said first axis only, and wherein relative movement along a second axis, essentially perpendicular to said first axis, between the work head and a working surface or working area is achieved by movement of said working surface or working area along said second axis.

**36.** A component mounting machine arranged for mounting electronic components onto substrates, comprising a positioning system as claimed in any one of claims 25-35.

**37.** A jetting machine for jet dispensing of viscous medium onto substrates, comprising a positioning system as claimed in any one of claims 25-35.

**38.** A dispensing machine for dispensing of viscous medium onto substrates, comprising a positioning system as claimed in any one of claims 25-35.
